# FASCICULE DE BREVET EUROPEEN

(11) **EP 0 709 903 B1**
(45) Date de publication et mention de la délivrance du brevet: **01.07.1998**
(21) Numéro de dépôt: 95402366.9
(22) Date de dépôt: 24.10.1995
(51) Int. Cl.: H01L 39/24

(54) **Procédé pour la préparation d'un substrat en vue du dépôt d'une couche mince de matériau supraconducteur**
Verfahren zur Herstellung eines Substrats für das Aufbringen einer Dünnschicht aus supraleitenden Materialien
Method for preparing a substrate for the deposition of a thin film of superconducting material

(30) Priorité: 27.10.1994 FR 9412882
(43) Date de publication de la demande: 01.05.1996
(73) Titulaire: ALCATEL ALSTHOM COMPAGNIE GENERALE D'ELECTRICITE, 75382 Paris Cédex 08 (FR)
(72) Inventeur: Belouet, Christian, F-92330 Sceaux (FR); Chambonnet, Didier, F-92320 Chatillon (FR)
(74) Mandataire: Fournier, Michel

(56) Documents cités:
- EP-A- 0 327 493
- US-A- 4 940 693
- US-A- 5 262 394

## Description

La présente invention concerne le dépôt, sur des substrats cristallins, de couches minces d'un matériau supraconducteur.

L'utilisation de films minces de matériau supraconducteur, notamment de supraconducteur dit à haute température critique, est appelée à connaître un grand développement, en particulier pour des applications hyperfréquences, en instrumentation électronique, etc...

Dans la plupart de ces applications, il est presque toujours indispensable d'obtenir des couches monocristallines, de manière à permettre la propagation sans perturbation des ondes électriques.

Une méthode connue dans la technique des semiconducteurs pour obtenir une couche monocristalline d'un matériau sur un substrat est la méthode épitaxiale; elle nécessite pour sa mise en oeuvre, que la maille cristalline du matériau déposé soit égale ou très voisine de celle du substrat.

Cette méthode n'est pas applicable directement dans le cas des matériaux supraconducteurs à haute température tels que l'Y-Ba-Cu-O (dont la formule exacte est YBa₂Cu₃O_{7.5}), car leur maille cristalline diffère de celle des substrats habituellement utilisés.

On connaît également une méthode de dépôt de couche mince sur un substrat, appelée méthode hétéro-épitaxiale, et qui consiste à interposer, entre le substrat et le matériau à déposer, une couche d'un matériau dont la dimension de la maille cristalline est intermédiaire entre celle du substrat et celle du matériau à déposer. Une telle méthode est connue du document US-A-5,262,394.

Cette méthode permet d'obtenir une couche plus régulière que celle qui serait obtenue sans la présence de la couche intermédiaire, mais cette couche est encore trop irrégulière pour les applications envisagées.

Un but de la présente invention est de définir un procédé permettant de réaliser un dépôt d'une couche d'un matériau supra conducteur Y-Ba-Cu-O parfaitement régulière et monocristalline sur un substrat.

L'invention est maintenant précisée par la description d'un exemple de mise en oeuvre du procédé de l'invention.

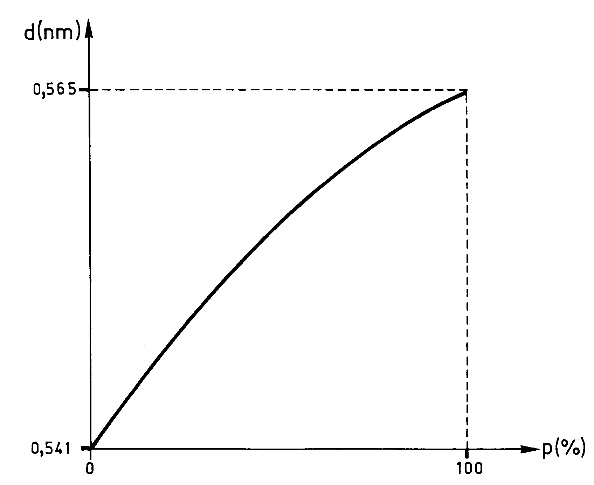

On se référera à la figure unique qui est un diagramme représentant la dimension d de la maille cristalline de la cérine CeO2 en fonction du pourcentage p d'oxyde de lanthane La2O3.

Le procédé de la présente invention est celui du dépôt, sur un substrat en SrTiO3 d'un film d'Y-Ba-Cu-O.

La dimension de la maille cristalline du SrTiO3 est égale à 0,552 nm (nanomètre) et celle d'Y-Ba-Cu-O de 0,5496 nm. Cette différence de dimension ne permet pas de réaliser une épitaxie qui nécessite des dimensions de mailles égales.

Selon l'invention, on utilise un matériau intermédiaire qui est la cérine CeO2 dopée par l'oxyde de lanthane. Ce composé a la propriété d'avoir une maille dont la dimension varie de 0,541 nm à 0,565 nm lorsque la proportion d'oxyde de lanthane varie de 0 à 100%, comme le montre la figure.

Le procédé de l'invention est de préférence mis en oeuvre par la technique dite PLD (abréviation de la locution anglaise: Pulsed Laser-assisted Deposition) qui est rappelée succintement ici.

On bombarde, avec un laser pulsé, alternativement une cible de cérine et une cible d'oxyde de lanthane, à proximité du substrat de SrTiO3. Les impulsions du laser ont des durées par exemple de l'ordre de 30 nanosecondes avec une fréquence pouvant varier de 1 à 100Hz. Les durées respectives de bombardement de la cérine et du dopant sont progressivement changées pour que la proportion de dopant dans la cérine varie progressivement de manière que la dimension de la maille du matériau déposée sur le substrat aille en décroissant de 0,5521 nm à 0,5496nm.

La lenteur relative de la vitesse de dépôt et la fréquence élevée de fonctionnement du laser permettent une variation très régulière de la composition du matériau intermédiaire au cours du processus, et par suite, une variation très régulière de la dimension de la maille cristalline du matériau déposé sur le substrat.

Le substrat ayant été traité comme indiqué, il est possible alors de déposer le matériau supraconducteur par hétéro-épitaxie et obtenir une couche monocristalline de très bonne qualité.

L'invention n'est pas limitée à l'exemple décrit mais s'applique toutes les fois qu'il est possible de trouver un matériau intermédiaire dont la dimension de la maille cristalline varie selon la proportion d'un dopant, de façon à s'ajuster à la maille cristalline du produit à déposer.

## Revendications

1. Procédé de dépôt d'une couche mince monocristalline d'un matériau supraconducteur Y-Ba-Cu-O sur un substrat de formule SrTiO3, caractérisé en ce qu'il comprend les étapes suivantes:
- on dépose sur le substrat par une méthode d'ablation laser pulsé, de la cérine Ce02 dopée à l'oxyde de lanthane, la dimension de la maille de ce composé ayant la propriété de varier avec la proportion d'oxyde de lanthane, en faisant varier progressivement la proportion d'oxyde de lanthane dans la cérine d'une première valeur pour laquelle la dimension de la maille cristalline de la cérine dopée est sensiblement égale à 0,5521 nm qui est la dimension de la maille cristalline du substrat SrTiO3, jusqu'à une seconde valeur pour laquelle la dimension de la maille cristalline de la cérine dopée est sensiblement égale à 0,5496 nm qui est la dimension de la maille du matériau supraconducteur Y-Ba-Cu-O,
- on arrête le dépôt de cérine dopée lorsque ladite seconde valeur est atteinte,
- on dépose le matériau supraconducteur Y-Ba-Cu-O par une méthode d'hétéro-épitaxie.

## Patentansprüche

1. Verfahren zum Abscheiden einer einkristallinen dünnen Schicht aus einem supraleitfähigen Y-Ba-Cu-O-Material auf einem Substrat der Formel SrTiO₃, **dadurch gekennzeichnet,** dass es folgende Schritte umfasst:
- Abscheiden von mit Lanthanoxid dotiertem Ceroxid CeO₃ auf dem Substrat durch ein Ablationsverfahren mit einem gepulsten Laser, wobei die Zellenabmessung dieser Verbindung die Eigenschaft hat, sich mit dem Anteil an Lanthanoxid zu ändern, wobei der Anteil an Lanthanoxid im Ceroxid progressiv von einem ersten Wert, bei dem die Abmessung der Kristallzelle des dotierten Ceroxids im wesentlichen gleich 0,5521 nm, der Abmessung der Kristallzelle des SrTiO₃-Substrates, ist, bis zu einem zweiten Wert verändert wird, bei dem die Abmessung der Kristallzelle des dotierten Ceroxids im wesentlichen gleich 0,5496 nm ist, der Abmessung der Kristallzelle des supraleitfähigen Y-Ba-Cu-O-Materials,
- Anhalten der Abscheidung von dotiertem Ceroxid, wenn der zweite Wert erreicht ist,
- Abscheiden des supraleitfähigen Y-Ba-Cu-O-Materials durch ein Hetero-Epitaxieverfahren.

## Claims

1. A method of depositing a thin monocrystalline layer of a superconductive material Y-Ba-Cu-O on a substrate of formula SrTiO₃, the method being characterized in that it comprises the following steps:
depositing the albanite CeO₂ doped with lanthanum oxide on the substrate by a method of ablation by means of a pulsed laser, the lattice constant of this compound having the property of varying with the proportion of lanthanum oxide, causing the proportion of lanthanum oxide in the albanite to vary progressively from a first value for which the crystal lattice constant of the doped albanite is substantially equal to 0.5521 nm, which is the crystal lattice constant of the substrate SrTiO₃, to a second value for which the crystal lattice constant of the doped albanite is substantially equal to 0.5496 nm, which is the lattice constant of the superconductive material Y-Ba-Cu-O;
stopping the deposit of doped albanite when said second value is reached; and
depositing the superconductive material Y-Ba-Cu-O by a hetero-epitaxial method.
